# EUROPEAN PATENT SPECIFICATION

(11) **EP 0 416 190 B1**
(45) Date of publication and mention of the grant of the patent: **01.06.1994**
(21) Application number: 89810668.7
(22) Date of filing: 07.09.1989
(51) Int. Cl.: H01S 3/025

(54) **Method for mirror passivation of semiconductor laser diodes**
Verfahren zur Spiegelpassivierung bei Halbleiterlaserdioden
Méthode de passivation des miroirs des diodes laser à semi-conducteur

(43) Date of publication of application: 13.03.1991
(73) Proprietor: International Business Machines Corporation, Armonk, N.Y. 10504 (US)
(72) Inventor: Gasser, Marcel, CH-8041 Zurich (CH); Latta, Ernst Eberhard, Dr., CH-8134 Adliswil (CH)
(74) Representative: Barth, Carl Otto

(56) References cited:
- DE-A- 3 006 949
- DE-A- 3 711 615
- US-A- 4 612 211
- US-A- 4 656 638
- IEEE TRANSACTIONS ON ELECTRON DEVICES, vol. ED-34, no. 11, November 1987, pages 2378-3379, New York, US; M. UCHIDA et al.: "Novel AlGaAs laser with high-quality mirror fabricated by reactive ion-beam etching and In-Situ passivation using enclosed UHV processing system"

## Description

### TECHNICAL FIELD

The invention concerns a method for passivating mirrors of semiconductor laser diodes to avoid degradation of device performance due to mirror contamination. According to the inventive method, which is applicable to both, cleaved and etched mirror devices, a passivation layer of suitable material is deposited "in-situ" on contamination-free mirror facets.

### BACKGROUND OF THE INVENTION

Semiconductor laser diodes have found applications in a wide variety of information handling systems because of their compact size and because their technology is compatible with that of the associated electronic circuitry. They are being employed in areas such as data communications, optical storage and optical printing. Most commonly used are group III/V compound materials. Particularly AlGaAs lasers have found extensive usage.

Historically, the mirror facets have been obtained by cleaving the laser bars, i.e.,layered structures forming the active waveguide of the device. Cleaving usually provides single, often high quality devices which require, however, further individual processing and testing. More recently, there is a strong trend to increase the scale of integration which requires the replacement of at least one cleaved mirror facet of the laser diodes by an etched mirror. Since substantial progress has been made in obtaining good quality etched mirrors, this technology appears to be very promising. It allows processes like mirror coating and testing to be performed on the water level - with the benefit of reduced handling, increased yield, and decreased fabrication and testing costs.

For both types of lasers, i.e., those with cleaved and those with etched mirrors, one of the most important and critical device criteria is the reliability and thus the maximum lifetime of the device at the output power levels required for the various applications. Reliability and device lifetime are heavily affected by mirror contamination and degradation which lead to device heating and finally to device destruction.

Over a long period of time, in fact for more than a decade, proposals and attempts have been made trying to solve these problems. Most successful has been the coating of the mirror facets with passivation layers which are applied to protect the mirror surfaces against contamination during the lifetime of the device.

Some of these approaches, illustrating the development of the passivation techniques and representing the present state of the art, are described in the following publications :
- Article "Effects of facet coatings on the degradation characteristics of GaAs-GaAlAs DH lasers" by Y.Shima et al (Appl.Phys.Lett., Vol.31, No.9, 1 November 1977, pp 625-627), probably contains the first discussion of the influence of facet coating on AlGaAs laser degradation. The authors achieved drastic improvements of the slow degradation rates and of the maximum power output by covering cleaved mirrors with SiO₂ or Al₂O₃. For Al₂O₃, an optimum degradation rate of about -0.001/hour at 2 mW/µm light output was obtained.
- Article "Insulating carbon coating on (AlGa)As DH laser facets" by T.Furuse et al (Appl.Phys.Lett., Vol.44, No.4, 15 August 1978, pp 317-318), reports on a further improvement of the degradation rate by applying a carbon coating. The authors obtained stable lasing operations at 4 mW for over 6000 hours.
- Article "High-power-density single-mode operation of GaAs-GaAlAs TJS lasers utilizing Si₃N₄ plasma deposition for facet coating" by H.Namizaki et al (J.Appl.Phys. 50(5), May 1979, pp 3743-3745), describes a method of laser diode facet coating involving plasma deposition of Si₃N₄ onto the mirror surface.It was found that, after 1000 hours of operation at 4 mW/µm, there is little change in the operating current. Actual figures are not reported,
- Article "Pulsed-power performance and stability of 800 nm GaAlAs/GaAs oxide-stripe lasers" by F.Kappeler et al (IEE Proc., Vol.129 pt.1, No.6, December 1082, pp 256-261), reports on experimental results and theoretical investigations of AlGaAs/GaAs lasers under pulsed power conditions. The authors used Al₂O₃ coated mirrors and applied an argon ion sputter process for precleaning of the mirror facets prior to the deposition of the passivation. This apparently did not result in any substantial improvement of the maximum obtainable output; in fact, high-energy sputtering, causing surface defects, seems to have had a negative effect.
- Article "Novel AlGaAs Laser with High-Quality Mirror Fabricated by Reactive Ion-Beam Etching and In-Situ Passivation Using Enclosed UHV Processing System", by M. Uchida et al. (IEEE Transactions on Electron Devices, Vol.ED-34, No.11, November 1987, pp. 2378-2379) relates to another approach for the passivation of etched mirror facets, again using Al₂O₃ as passivation layer. This passivation layer has to be annealed prior to operate the laser.
- Article "Reactive outdiffusion of contaminants from (AlGa)As laser facets" by P.Tihanyi et al (Appl.Phys.Lett., Vol.42, No.4, 15 February 1983, pp 313-315), describes a different approach for precleaning the mirror surface. The authors deposited a thin, metallic Al film directly onto the air-cleaved facet and claim that this process eliminates a large part of surface contaminations due to the gettering effect of the Al. Data on laser performance are not given.
- Article "High-power 0.87 micron Channel Substrate Planar Lasers for Spacaborne Communications" by J.C.Connolly et a (SPIE 885 Free-Space Laser Communication Technologies, 1988, pp 124-130), represents the present state of the art of high performance AlGaAs lasers. It is a report on one of the best lasers so far known. Passivation was obtained with optimized Al₂O₃ deposition techniques, and the device allowed single mode operation up to around 200 mW where immediate catastrophic optical damage occurred. In lifetests at 50 mW (50% duty-cycle) and room temperature, devices have operated over 5000 hours with little or no change in drive current. For higher power levels (but below 200 mW), no lifetime data are reported.

To the best of our knowledge, high performance lasers so far built or reported, still suffer from a number of deficiencies :
- Continuous operation output powers of above 200 mW are still not possible for an extended period of time;
- For operation at about 50 mW continuous output power, the lowest degradation rates achieved are between 10⁻⁵ and 10⁻⁶ per hour, i.e., device lifetimes are still rather limited, and
- The devices undergo a "burn-in" phase during which the output power shows a substantial decrease until the slow degradation phase is reached after about 100 hours operating time.

As demonstrated by the above cited publications, a number of different processes have been suggested for the passivation of the mirror surfaces. However, no reference is known to disclose or suggest an in-situ deposition of the passivation layer onto a contamination-free mirror surface, a process that has now been found to provide superior results and that is being used in the process described hereinafter.

In addition, passivation layers consisting of amorphous silicon and hydrogen, e.g. Si₁₋ₓHₓ, are disclosed in the German Patent DE-A- 3 006 949. The thickness of these passivation layers is typically λ/4* m, i.e. greater than 200 nm.

Also, a variety of materials has been suggested for mirror passivation but no publication is known to make reference to the use of Si, Ge or Sb that lead to the improvements achieved with the present invention. This is surprising in that the use of Si in the fabrication and design of other GaAs technology devices has been suggested before. An example is a MOS transistor fabrication process disclosed in the article "Unpinned GaAs MOS Capacitors and Transistors" by S.Tiwary et a (IEEE Electron Device Letters, Vol.9, No.9, September 1988, pp 488-490) where, in an intermediate process step, an extremely thin MBE-grown Si terminating layer is applied to the GaAs transistor channel surface; in a subsequent chemical SiO₂ deposition process, the Si layer is consumed into the oxide film, as required for the proper operation of the MOS device.

The object of the present invention is to provide a method for the deposition of passivation layers for the effective protection of laser mirrors against contamination, thereby avoiding early device deterioration.

### SUMMARY OF THE INVENTION

The invention as claimed is intended to meet these objectives and to remedy the deficiencies of known laser diode fabrication techniques. The inventive method solves the problems hitherto encountered in that a contamination-free mirror facet is provided onto which a continuous, insulating or low conductive passivation layer is applied "in-situ", the passivation layer being formed of a material that prevents diffusion of species capable of reacting with the mirror facet interface, that does not react itself with the mirror material, and that does not contain oxygen. In a preferred embodiment, Si is used. Other suitable materials are Ge and Sb.

The main advantages offered by the invention are that semiconductor laser diodes fabricated in accordance with the inventive process exhibit a substantially improved degradation behavior resulting in very high power lasers of superior reliability and thus increased lifetime: in addition, these lasers, when in operation, don't undergo an initial, fast degradation "burn-in" phase.

### DESCRIPTION OF THE DRAWINGS

The invention is described in detail below with reference to drawings which illustrate a specific embodiment as well as performance characteristics of devices fabricated in accordance with the teaching of the invention, and in which
- **Fig. 1**: is a perspective view of a laser bar consisting of a ridge GRINSCH structure to which the inventive method of forming contamination-free mirrors, followed by in-situ passivation, can be applied.
- **Fig. 2.A**: is a perspective view of a carrier device for supporting the laser bar when processed in a vacuum chamber.

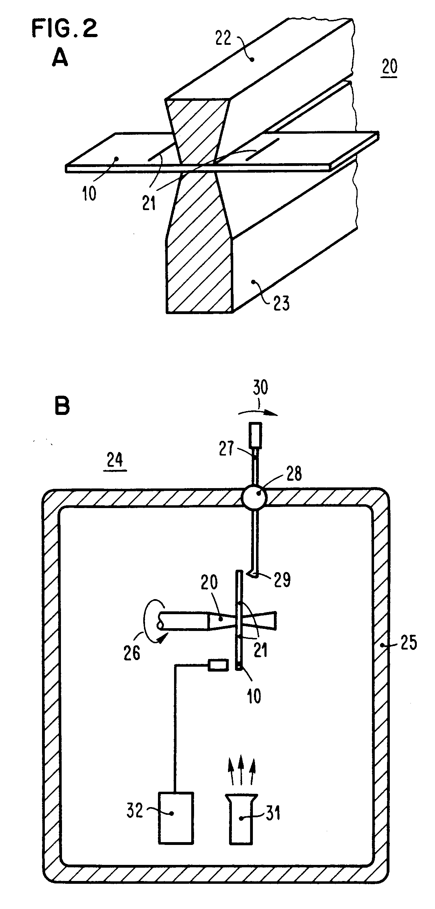

- **Fig. 2.B**: is a schematice representation of a vacuum chamber in which the contamination-free laser mirror facets are formed and passivated.

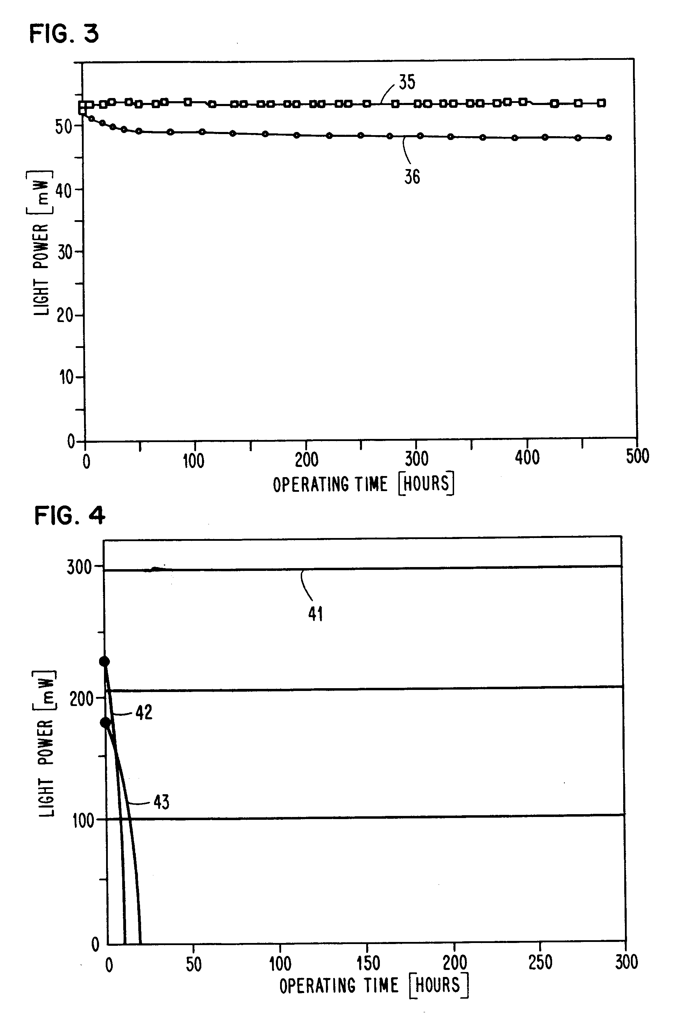

- **Fig. 3**: shows laser current degradation curves of cleaved mirror lasers with (1) a 20 nm Si passivation, and (2) a conventional Al₂O₃ coating.
- **Fig. 4**: shows a light power/operating time (at a power level of about 300 mW) diagram of a cleaved mirror laser with a 1 nm Si passivation and an additional Si₃N₄ protective coating; it is compared with diagrams of conventional, Si₃N₄ -coated devices (operated and destroyed at lower power levels).

### DETAILED DESCRIPTION

Before describing the invention in greater detail, the purpose and the basic concept underlying the invention will be briefly outlined by referring to the experiences and problems encountered with hitherto known processes and devices.

Important steps in the fabrication process of AlGaAs (or other III/V compound) laser diodes are the preparation of the mirrors, conventionally by cleaving, nowadays also by etching, and their subsequent passivation. The standard procedure has been to cleave the laser bar (i.e., the layered structure forming the laser waveguide) in air, and to quickly transfer it to a vacuum system where a protective passivation layer is deposited onto the mirror facets. The role of this layer is twofold : (1) it should protect the mirror surfaces against corrosion, and (2) it should reduce the number of electrical surface traps resulting from crystal defects. Both these effects are considered to be responsible for the energy dissipation during laser operation which results in mirror degradation and, finally, in excessive heating of the facets and irreversible catastrophic damage of the device. Despite the application of passivation layers, the lifetime of presently known lasers is still limited by these degradation mechanisms. Typical light output versus operating time diagrams, recorded at constant current applied to the laser, show an initial fast decrease - the so-called "burn-in" phase - and a normally long phase of smaller degradation rate with nearly constant slope.

As stated above, the role of the passivation layer is to prevent any interaction between the surrounding atmosphere and the AlGaAs while the laser is in operation. But there exists no such protection against species that are already present at the mirror surface when the passivation layer is applied because the mirror has been exposed to air. Contamination at the AlGaAs - coating interface is then unavoidable. This is what can be prevented by the present invention.

A first key point of the present invention is, therefore, to provide a contamination-free mirror facet and to apply the passivation layer while the laser is still in the same atmosphere which, of course, must not lead to surface contamination.

For cleaved mirror devices, this can be accomplished by performing the cleaving and the subsequent deposition of the protective layer "in-situ", e.g., in a vacuum system with sufficiently low base pressure.

In the case of etched laser devices, the same principle can be applied. The etched mirror facets are, when necessary after a cleaning process to obtain a contamination-free surface, in-situ-coated with the protective layer.

The applied protective layer can be either the final passivation layer or a thin layer which has to protect the AlGaAs surface only until an additional thicker film is deposited, possibly in a different environment.

The second key point is the choice of a proper material for the passivation. For different, partly unknown reasons, the materials used today, mainly SiO₂ and Al₂O₃, do not result in the desired performance of the lasers. This aspect required some fundamental consideration and extensive probing.

The passivation layer must act as a diffusion barrier for those species capable of reacting with AlGaAs and, of course, must not react itself with the mirror material. Since Al, Ga and As do form stable oxides, oxygen as well as OH or H₂O should not be contained in the material near the laser mirror. So, oxides are disregarded. Another requirement is that the conductivity of the passivation layer has to be sufficiently low to avoid significant currents across the mirror facet. This eliminates highly conductive materials, such as metals, unless the layers are made very thin. On the other hand, the material must form a continuous layer without pinholes and pores.

In the tests made, best results have been obtained using Si, but first experiments have shown that Ge and Sb can also be suitable passivation materials.

Following is a detailed description of an example of the inventive method where the passivation layer is deposited on a cleaved mirror facet.

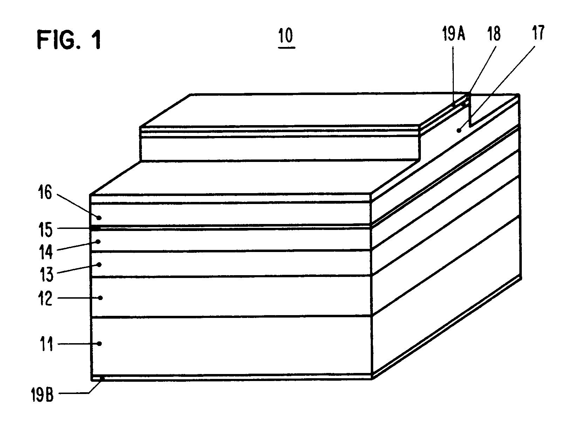

First, a laser bar is produced, i.e., an epitaxially grown layered structure forming a waveguide which, when both its ends are terminated with a mirror facet, serves as the laser cavity. Such bar structure is schematically shown in Fig.1. It can be the same and fabricated using the same process as that described in an article by C.Harder et al, entitled "High-Power Ridge-Waveguide AlGaAs GRINSCH Laser Diode", published in Electronics Letters, 25th September 1986, Vol.22, No.20, pp 1081-1082.

Briefly, the sequence of steps for producing the layered structure 10 is as follows :
The layers are grown on an n + -doped GaAs substrate 11 by, e.g., molecular beam epitaxy (MBE). First, an n-doped GaAs buffer layer 12 is grown on the substrate. Next is a lower, n-type cladding layer 13 (0.2 µm Al_{0.45}Ga_{0.55}As ). The core of the laser consists of a graded n-type region 14 (0.2 µm Al_{0.45}Ga_{0.55}As graded towards Al_{0.18}Ga_{0.82}As), an undoped region 15, forming a quantum well (7 nm GaAs), and a graded p-type region 16 (0.2 µm Al_{0.18}Ga_{0.82}As graded towards Al_{0.45}Ga_{0.55}As). Next is the top cladding layer 17 (Al_{0.45}Ga_{0.55}As), followed by a p+ -GaAs contact layer 18 with a doping density that is high enough for a titanium-platinum-gold electrode 19A to make good ohmic contact. Another ohmic contact 19B, at the bottom of the n-type substrate 11, is obtained by alloying germanium, gold and nickel.

When needed for lateral waveguiding, a ridge, about 5 µm wide, can be formed on top of the structure (as shown in Fig.1) prior to applying the metal contact electrodes. The ridge is obtained by first applying a photoresist mask to define the ridge. Subsequently, 1 or 2 µm of the exposed top layers are etched, etching being stopped 0.2 µm above the graded-index part of the the top cladding layer.

The further processing of the laser bar 10 will now be described with the aid of the schematic illustrations of Fig.2 showing an experimental arrangement. Bar 10, having a length of some millimeter, is scratched to provide two scribe lines 21, 750 µm apart, defining the position where cleaving and mirror formation is to take place. It is mounted in a carrier 20 as shown in Fig. 2A. Bar 10 is held between an upper (22) and a lower (23) member which apply (through a mechanism not shown) a gentle pressure to keep the bar in place during subsequent process steps.

The carrier 20, with the laser bar mounted, is then placed into a vacuum system 24 as illustrated in Fig.2B. System 24 comprises an UHV chamber 25 of which only the outer walls are shown, omitting, for simplicity reasons, inlets and outlets, electrical connections, etc. In the chamber, carrier 20 is arranged such that it can be mechanically manipulated from outside the chamber. For instance, it can be turned around its horizontal axis as indicated by arrow 26. The chamber is also equipped with a lever or "wobble stick" 27, entering the chamber through a metal bellow 28 allowing for mechanical movement of the tip 29 within the vacuum chamber. With the relative position between the lever 27 and bar 10 as shown, moving the outer arm of the lever to the right, as indicated by arrow 30, allows tip 29 to apply a force upon the upper end of the laser bar 10.

In the chamber 25, there is furthermore provided an e-beam evaporation source 31 for Si deposition as well as a quartz-crystal oscillator 32 suitable for monitoring the thickness of the deposited layer during e-beam evaporation. The vacuum system, the evaporation source and the crystal oscillator operation are not described in detail since they are well known in the art. Reference is made to a "Handbook of Thin Film Technology", edited by L.I.Maissel and R.Glang (McGraw-Hill, 1970).

With the system illustrated in Fig.2B, the sequence of the required process steps for cleaving and passivating is as follows :
- After placing the carrier 20 with the laser bar 10 into chamber 25, chamber pressure is reduced to about 5 x 10⁻⁸Pa. The following process steps can be carried out at room temperature.
- Moving the end of lever 27 extending outside the chamber to the right, causes tip 29, located near the upper end of the laser bar 10, to move to the left and to break off that end of the bar at the respective scribe line 21, thereby forming the first mirror facet.
- After turning carrier 20 by 180 degrees about its horizontal axis, the same process is repeated, resulting in breaking off the second laser bar end at the respective scribe line, thus forming the second mirror facet.
- Activation of the e-beam evaporation source 31 then causes the deposition of an amorphous silicon layer onto the exposed mirror facet facing the source. The evaporation process is terminated when the thickness of the layer, monitored by crystal oscillator 32, reaches the desired value, e.g., 20 nm. By adjusting the electron acceleration voltage, the evaporation rate can be set so that the deposition process takes about one minute.
- After turning carrier 20 again by 180 degrees, the same evaporation process is repeated, resulting in the deposition of a silicon layer on the second mirror facet.

With this last process step, the passivation coating is completed and, after packaging, the laser element is ready for use.

The diagram of Fig.3 illustrates, for a laser produced with the just described process (curve 35), i.e., a laser with a 20 nm thick Si passivation layer, and for a conventional, Al₂O₃ -coated laser (curve 36), representing the current state of the art, how the laser power degrades with device operating time.

Curve 35 shows, for the Si-passivated laser, the output power obtained when applying a constant laser current (168 mA) over a period of 500 hours at room temperature. Curve 36, in the same diagram, represents the corresponding measurement of a virtually identical laser, except that a conventional Al₂O₃ coating had been applied instead of the Si passivation.

The diagram shows the device behavior during the first 500 hours of continuous operation. The superior performance of the Si-coated device, represented by curve 35, is evident : (1) there is virtually no burn-in phase, i.e., the laser is ready for use immediately after its fabrication, and (2) the degradation rate has been determined to be as low as 8.4 x 10⁻⁷/hour. Testing of the device has been continued for more than 5000 hours operating time and has proven that the degradation rate remained at practically the same low level.

Particularly for high power devices, it proved to be useful to reduce the Si-film thickness to, e.g., 1 nm, in which case, however, an additional thick protective coating is required which may consist of Si₃N₄.

For such lasers, extremely high light output powers have been achieved as can be seen from the light-power versus operating time diagram of Fig.4. Curve 41 represents the performance of a 5 µm ridge GRINSCH laser (as described in the C.Harder et al article cited above) with a 1 nm Si / 140 nm Si₃N₄ passivation coating. A 300 mW output beam has been maintained for over 300 hours without any measurable degradation.

In the same diagram, curves 42 and 43 represent two laser devices, fabricated on the same wafer and identical to that of curve 41, except that their passivation did not contain the in-situ-applied Si. They have been operated applying laser currents initially resulting in a light output power of 220 and 180 mW, respectively, but quickly deteriorated and catastrophic optical damage occurred after a short operating time.

This comparison illustrates the superior "power-capabilities" of the in-situ Si-passivated devices : they allow continuous, long lasting operation at 300 mW and more, whereas the upper power limit for conventional devices is far below 150 mW.

First experiences have proven that lasers with mirrors protected by Ge or Sb layers, instead of Si, also exhibit a degradation behavior comparable to that of Si passivated devices if the layers are deposited onto uncontaminated mirror facets.

The application of the new Si-passivation concept is not limited to cleaved mirror devices. Any uncontaminated and stoichiometric mirror face can be protected. An example are dry etched mirror lasers which are expected to become increasingly important because they allow full wafer processing and testing, i.e., passivation coatings can be applied simultaneously to all devices formed on a wafer.

A process for fabricating high power etched mirror lasers with a Si passivation coating in accordance with the present invention can comprise the following process steps :
- Fabrication of the basic layered laser structure (as described in the C.Harder et al article cited above);
- Dry etching to produce the etched mirror facets (as described in European patent application 88.810613.5, filed on September 12, 1988 and assigned to the present applicant);
- Sputter cleaning of the etched facets to remove residuals of the etching process, e.g., with nitrogen/hydrogen ions, at 800 V and a pressure of 0.4 Pa, followed by annealing to remove surface defects;
- In-situ e-beam evaporation, i.e., without breaking vacuum in the system, of a 1 nm Si passivation film, and
- Sputter deposition of Si₃N₄ films of different thickness onto the mirrors at both ends of the laser waveguide, providing coatings of high and low reflectivity, respectively.

The invention has been described in detail as applied to the fabrication of specific AlGaAs ridge diode lasers with either cleaved or etched mirrors. It should, however, be understood that it is likewise applicable to other laser diode structures, and to devices consisting of compound semiconductors other than AlGaAs. Also, processes and device parameters may be different from those indicated herein above. For instance, the Si layers may be epitaxially grown using a MBE process, then being crystalline rather than amorphous, and further or different (other than Si₃N₄) coatings may be deposited onto the Si (or Ge, Sb) layer first applied to the mirror surface.

The key aspects of the invention can be summarized as follows :
- The process of forming a contamination-free mirror surface, either by cleaving or by cleaning of etched mirror surfaces, and the subsequent mirror passivation are executed in-situ in an environment not causing mirror contamination.
- The passivation layer must be continuous, either insulating or of low conductivity, and of a material that acts as a diffusion barrier for species capable of reacting with the mirror surface and that does not react itself with the mirror material. Suitable passivation materials are Si, Ge and Sb.
- Laser diode devices fabricated in accordance with the described method are less affected by the "burn-in" phase, show a significant improvement of the extrapolated lifetime, and, for a number of applications most important, allow continuous operation at drastically increased output power levels of above 300 mW at room temperature.

## Claims

1. Method for mirror passivation of semiconductor laser diodes
comprising the steps of :
- providing a layered semiconductor structure forming the active waveguide of the laser diode,
- processing said layered structure to provide contamination-free mirror facets terminating said active waveguide and determining the length of the laser diode cavity, and
- depositing a passivation layer in-situ, i.e. in the same environment in which the formation of the contamination-free laser facets took place, onto said contamination-free mirror facets, said passivation layer being continuous, pinhole-free and either insulating or of low conductivity to prevent current flow across the mirror facet, and formed of a material that
a) prevents diffusion of species capable of reacting with the mirror facet interface,
b) does not react itself with the mirror facet interface, and that
c) does not contain oxygen.

2. A method as in claim 1, wherein said passivation layer consists of a material from the group comprising silicon, germanium, and antimony, said semiconductor laser diode comprising AlGaAs.

3. A method as in claim 2, wherein said passivation layer consists of silicon.

4. A method as in claim 3, wherein said passivation layer consists of amorphous silicon.

5. A method as in claim 1, wherein the thickness of said passivation layer is between 10 and 100 nm.

6. A method as in claim 1, wherein said passivation layer consists of a first, thin layer having a thickness of between 0.5 nm and 5 nm, and a thicker layer of a different material having a thickness of 100 nm or more.

7. A method as in claim 6, wherein said first, thin layer consists of Si, said thicker layer of Si₃N₄.

8. A method as in claim 1, wherein said contamination-free mirror facets are obtained by cleaving said layered structure in an environment that does not lead to facet contamination.

9. A method as in claim 8, wherein said passivation layer is deposited onto the cleaved, contamination-free mirror facets while the laser diode structure is still in the same environment in which cleaving took place.

10. A method as in claim 8 or 9, wherein said environment is a vacuum with a pressure of below 10⁻⁶ Pa.

11. A method as in claim 1, wherein said contamination-free mirror facets are obtained using a dry-etching process followed by plasma cleaning in an environment not leading to facet contamination.

12. A method as in claim 11, wherein said passivation layer is deposited onto the cleaned, contamination-free mirror facets while the laser diode structure is still in the same environment in which plasma cleaning took place.

13. A method as in claim 1, wherein said contamination-free mirror facets are obtained in an dry-etch process and where said passivation layer is deposited onto the etched contamination-free mirror facets while the laser diode structure is still in the same environment in which etching took place.

14. A method as in claim 11, wherein said plasma cleaning is followed by an annealing process to remove facet surface defects.

## Patentansprüche

1. Verfahren zur Spiegelpassivierung bei Halbleiterlaserdioden, bestehend aus folgenden Schritten:
- Bereitstellung einer geschichteten Halbleiterstruktur, die die aktive Wellenführung der Laserdiode bildet,
- Verarbeitung der genannten geschichteten Struktur, um verschmutzungsfreie Spiegelfacetten bereitzustellen, die diese aktive Wellenführung beenden und die Länge der Laserdiodengrube bestimmen, und
- Auftragen einer Passivierungsschicht im Unterdruck, das heißt, in derselben Umgebung, in der die Bildung der verschmutzungsfreien Laserfacetten stattgefunden hat, auf die genannten verschmutzungsfreien Spiegelfacetten, wobei diese Passivierungsschicht kontinuierlich, frei von jeglichen Vertiefungen und entweder isolierend oder von geringer Leitfähigkeit ist, um so einen Stromfluß auf der Spiegelfacette zu vermeiden, und bestehend aus einem Material, das
a) die Diffusion von Stoffen verhindert, die mit der Schnittstelle der Spiegelfacette reagieren können,
b) selbst nicht mit der Schnittstelle der Spiegelfacette reagiert, und
c) keinen Sauerstoff enthält.

2. Ein Verfahren gemäß Anspruch 1, bei dem die genannte Passivierungsschicht aus einem Material der Gruppe, die Silizium, Germanium und Antimon umfaßt, besteht, wobei die genannte Halbleiterlaserdiode AlGaAs umfaßt.

3. Ein Verfahren gemäß Anspruch 2, bei dem die genannte Passivierungsschicht aus Silizium besteht.

4. Ein Verfahren gemäß Anspruch 3, bei dem die genannte Passivierungsschicht aus amorphem Silizium besteht.

5. Ein Verfahren gemäß Anspruch 1, bei dem die Dicke der Passivierungsschicht zwischen 10 und 100 nm liegt.

6. Ein Verfahren gemäß Anspruch 1, bei dem die genannte Passivierungsschicht aus einer ersten dünnen Schicht mit einer Dicke zwischen 0,5 nm und 5 nm und aus einer zweiten dickeren Schicht aus einem anderen Material mit einer Dicke von 100 nm oder mehr besteht.

7. Ein Verfahren gemäß Anspruch 6, bei dem die genannte erste Schicht aus Si und die genannte zweite, dickere Schicht aus Si₃N₄ besteht.

8. Ein Verfahren gemäß Anspruch 1, bei dem die genannten verschmutzungsfreien Spiegelfacetten durch Spaltung der genannten geschichteten Struktur in einer Umgebung erzielt werden, in der keine Facettenverschmutzung möglich ist.

9. Ein Verfahren gemäß Anspruch 8, bei dem die genannte Passivierungsschicht auf die gespaltenen, verschmutzungsfreien Spiegelfacetten abgelagert wird, während sich die Laserdiodenstruktur noch immer in derselben Umgebung befindet, in der die Spaltung stattgefunden hat.

10. Ein Verfahren gemäß Anspruch 8 oder 9, bei dem es sich bei der genannten Umgebung um eine Unterdruckumgebung mit einem Druck von weniger als 10⁻⁶ Pa handelt.

11. Ein Verfahren gemäß Anspruch 1, bei dem die verschmutzungsfreien Spiegelfacetten durch Anwendung eines Trockenätzungsverfahrens, gefolgt von einer Plasmareinigung in einer Umgebung, in der keine Facettenverschmutzung möglich ist, erzielt werden.

12. Ein Verfahren gemäß Anspruch 11, bei dem die genannte Passivierungsschicht auf die gereinigten, verschmutzungsfreien Spiegelfacetten abgelagert wird, während sich die Laserdiodenstruktur noch immer in derselben Umgebung befindet, in der die Plasmareinigung stattgefunden hat.

13. Ein Verfahren gemäß Anspruch 1, bei dem die verschmutzungsfreien Spiegelfacetten durch Anwendung eines Trockenätzungsverfahrens erzielt werden, und bei dem die genannte Passivierungsschicht auf die geätzten, verschmutzungsfreien Spiegelfacetten aufgetragen wird, während sich die Laserdiodenstruktur noch immer in derselben Umgebung befindet, in der die Ätzung stattgefunden hat.

14. Ein Verfahren gemäß Anspruch 11, bei dem die genannte Plasmareinigung von einem Warmglühverfahren zur Beseitigung von Facettenoberflächenschäden gefolgt wird.

## Revendications

1. Méthode de passivation des miroirs des diodes laser à semi-conducteur comprenant les étapes de:
fournir une structure à semi-conducteur en couches formant le guide d'onde actif de la diode laser,
traiter ladite structure en couches pour fournir des facettes de miroir sans contamination terminant ledit guide d'onde actif et déterminant la longueur de la cavité de la diode laser, et
déposer une couche de passivation in-situ, c'est à dire dans le même environnement où la formation des facettes de miroir sans contamination a eu lieu, sur les facettes de miroir sans contamination, ladite couche de passivation étant continue, sans trous d'épingle, et soit isolante, soit de faible conductivité pour empêcher l'écoulement de courant à travers la facette de miroir, et formé d'un matériau qui:
a) empêche la diffusion d'éléments capables de réagir avec l'interface de la facette de miroir,
b) ne réagit pas lui-même avec l'interface de la facette de miroir, et
c) ne contient pas d'oxygène.

2. Méthode telle que dans la revendication 1, dans laquelle ladite couche de passivation consiste en un matériau du groupe contenant le silicium, le germanium et l'antimoine, ladite diode laser à semi-conducteur comprenant AlGaAs.

3. Méthode telle que dans la revendication 2, dans laquelle ladite couche de passivation est du silicium.

4. Méthode telle que dans la revendication 3, dans laquelle ladite couche de passivation est du silicium amorphe.

5. Méthode telle que dans la revendication 1, dans laquelle l'épaisseur de ladite couche de passivation est entre 10 et 100 nm.

6. Méthode telle que dans la revendication 1, dans laquelle ladite couche de passivation consiste en une première couche mince ayant une épaisseur entre 0,5 nm et 5 nm, et une couche plus épaisse d'un matériau différent ayant une épaisseur de 100 nm ou plus.

7. Méthode telle que dans la revendication 6, dans laquelle ladite première couche mince est du Si, ladite couche plus épaisse est du Si₃N₄.

8. Méthode telle que dans la revendication 1 dans laquelle lesdites facettes de miroir sans contamination sont obtenues en divisant ladite structure en couches dans un environnement qui ne provoque pas une contamination des facettes.

9. Méthode telle que dans la revendication 8, dans laquelle ladite couche de passivation est déposée sur les facettes de miroir sans contamination divisées alors que la structure de diode laser est encore dans le même environnement où a eu lieu la division.

10. Méthode telle que dans la revendication 8 ou 9, dans laquelle ledit environnement est un vide à une pression inférieure à 10⁻⁶ Pa.

11. Méthode telle que dans la revendication 1, dans laquelle lesdites facettes de miroir sans contamination sont obtenues en utilisant un procédé de gravure à sec suivi d'un nettoyage au plasma dans un environnement ne provoquant pas de contamination des facettes.

12. Méthode telle que dans la revendication 11, dans laquelle ladite couche de passivation est déposée sur les facettes du miroir sans contamination nettoyées alors que la structure de diode laser est encore dans le même environnement où a eu lieu le nettoyage au plasma.

13. Méthode telle que dans la revendication 1, dans laquelle lesdites facettes de miroir sans contamination sont obtenues par un procédé de gravure à sec et dans laquelle ladite couche de passivation est déposée sur les facettes de miroir sans contamination gravées alors que la structure de diode laser est dans le même environnement où a eu lieu la gravure.

14. Méthode telle que dans la revendication 11, dans laquelle ledit nettoyage au plasma est suivi d'un procédé de recuit pour supprimer les défauts de surface des facettes.
